# EUROPEAN PATENT APPLICATION

(11) **EP 0 535 814 A1**
(43) Date of publication of application: **07.04.1993**
(21) Application number: 92308271.3
(22) Date of filing: 11.09.1992
(51) Int. Cl.: H01L 29/784, H01L 29/06, H01L 21/76

(54) **Integrated circuit transistor structure and method**

(30) Priority: 30.09.1991 US 768839
(71) Applicant: SGS-THOMSON MICROELECTRONICS, INC., Carrollton Texas 75006 (US)
(72) Inventor: Sundaresan, Ravishankar, Garland, Texas 75040 (US)
(74) Representative: Palmer, Roger

(57) **Abstract**

A thin insulating layer is formed under the source/drain regions of a field effect device. This insulating layer is relatively shallow compared to the overall size of the device. The insulating layer is preferably formed by implanting a material, such as oxygen or nitrogen, into the substrate after gate definition. This forms an insulating layer which is self-aligned with the transistor gate.

## Description

The present invention relates generally to semiconductor integrated circuits, and more specifically to a method for forming field effect devices in integrated circuits and the resulting structure.

As is well known in the art, feature sizes for devices on semiconductor integrated circuits continue to decrease. This allows integrated circuit chips to be fabricated which have increasingly larger numbers of active components on a single die. In general, the continued reduction of feature sizes allows faster devices to be built less expensively than those fabricated using larger feature sizes.

As state of the art devices increasingly incorporate feature sizes well below one micron, a number of physical effects which are less noticeable or nonexistent with larger feature size devices become important. With field effect devices, small feature sizes imply very short transistor channel lengths, and a number of problems occur related to such short channels. One important problem which is known to occur relates to source/drain punch through, in which the extension of the drain depletion region into the channel can seriously impact the operation of a transistor.

One method commonly used to control source/drain punch through consists of increasing the impurity doping level in the transistor channel. However, this increased dopant level lowers the majority carrier mobility in the channel. This has the effect of decreasing the gain and switching speed of the transistor.

It would therefore be desirable to provide a semiconductor integrated circuit transistor structure, and a method for forming same, which provides improved transistor performance. A method for fabricating such device should be compatible with widely used semiconductor fabrication processes, and preferably adds minimal complexity to the fabrication process.

Therefore, according to the present invention, a thin insulating layer is formed under the source/drain regions of a field effect device. This insulating layer is relatively shallow compared to the overall size of the device. The insulating layer is preferably formed by implanting a material, such as oxygen or nitrogen, into the substrate after gate definition. This forms an insulating layer which is self-aligned with the transistor gate.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

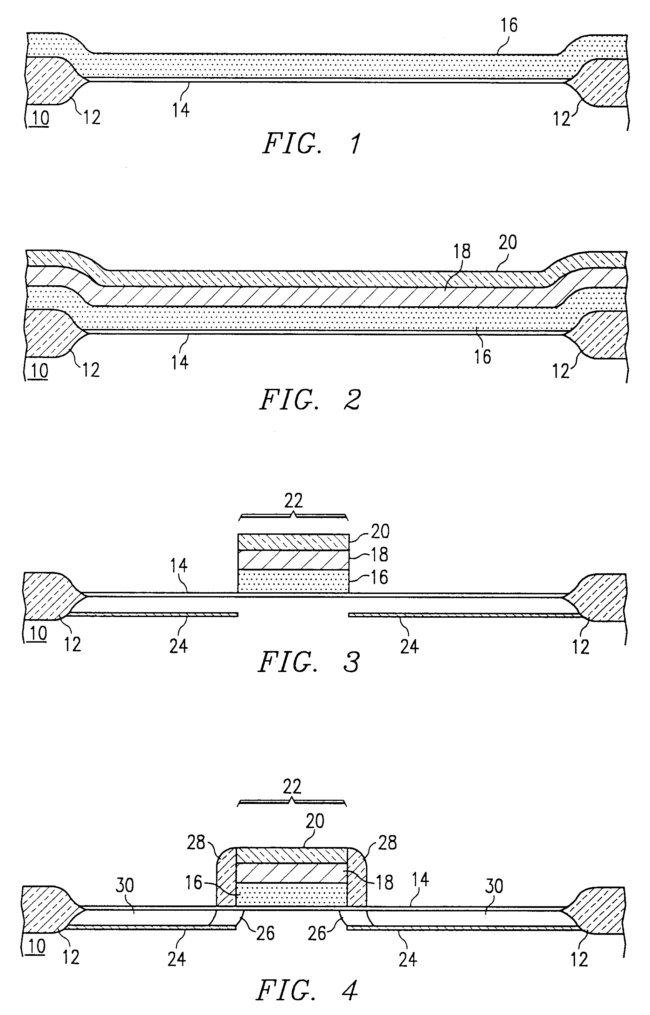

**Figures 1 - 4** illustrate a preferred method for forming a field effect device according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1**, a field effect transistor is to be formed in a substrate **10**. Assuming the device to be a complementary MOS (CMOS) device, p-wells and n-wells (not shown) are formed in the substrate **10** as known in the art. Field oxide regions **12** are formed within the substrate **10** and are used to separate active devices. The field oxide regions **12** shown in **Figure 1** have been formed as the result of local oxidation of silicon (LACOS), but any technique for forming field oxide regions may be utilized.

A gate oxide layer **14** is then grown over the substrate **10**, followed by deposition of a polycrystalline silicon layer **16** over the entire device. If desired, the polycrystalline silicon layer **16** may be doped to improve its conductivity.

Referring to **Figure 2**, a silicide layer **18** is formed over the polycrystalline layer **16**. This is done to improve the conductivity of gate and interconnect structures formed out of the polycrystalline layer **14**. As known in the art, refractory metals such as tantalum or tungsten may be used to form the silicide layer **18**. Layer **18** may be formed by direct deposition, or by depositing a layer of refractory metal followed by a heating step to react the refractory metal with the underlying polycrystalline layer **16**. Device fabrication to this point has been conventional.

Following the formation of the silicide layer **18**, an oxide layer **20** is formed over the device. Oxide layer **20** may be deposited using known techniques. If desired, other types of blocking layers, such as a thin oxide layer followed by a thicker nitride layer, may be used. The purpose of layer **20** will be to mask a later implant as will now be described.

Referring to **Figure 3**, the oxide layer **20**, silicide layer **18** and polycrystalline silicon layer **16** are patterned and etched to define a gate electrode **22**. Gate oxide layer **14** preferably remains behind on the substrate **10** in order to protect the substrate surface from following implant steps. If process parameter variability is not controlled as tightly as desired, the relatively thin gate oxide layer **14** may be partially etched away by the etch used to remove the unmasked portions of polycrystalline silicon layer **16**. In such case, it may be desirable to strip the exposed portions of oxide layer **14** and perform a sacrificial gate oxide regrowth step in order to provide a remaining layer **14** having uniform thickness.

Oxygen is then implanted into the substrate **10**. The oxygen will not penetrate to the substrate **10** through the field oxide layers **12**, or to the gate electrode **22** through the protective layer **20**. Proper selection of implant density and energy results in a layer of oxygen atoms lying below the surface of the substrate **10** and self-aligned with a gate electrode **22**. A heating step, preferably a rapid thermal anneal, is then performed to convert the oxygen atoms to a layer of oxide **24**.

Proper selection of implant energies will control the depth and thickness of the oxide layer **24**. For example, oxygen could be implanted at an energy of approximately 80 to 120 KeV to give an oxide layer **24** depth of approximately .25 micron. An implant density of approximately .5 x 10¹⁸/cm² will result in the thin oxide layer **24** having a thickness of approximately 2000 angstroms.

Referring to **Figure 4**, once the thin oxide layer **24** has been formed, conventional processing steps resume. These include a lightly doped drain (LDD) implant to form LDD regions **26**, followed by formation of oxide sidewall spacers **28** as known in the art. A heavy dopant implant then forms source/drain regions **30**. The remaining process steps, including formation of insulating layers and further interconnect layers, proceed using conventional techniques known in the art.

If desired, nitrogen can be implanted into the substrate **10** to form insulating layer **24** instead of oxygen. Upon annealing, this will result in insulating layer **24** formed of silicon nitride rather than oxide. If desired, it is also possible to form the insulating layer **24** after formation of the sidewall spacers **28**. This results in the insulating layer **24** being spaced further from the channel by approximately the width of the sidewall spacers **28**.

The transistor structure shown in **Figure 4** can be either a p-channel or an n-channel device. The process described above is implemented very easily for CMOS devices. If it is desirable to have the insulating layer **24** under both p-channel and n-channel devices, a single implant can be made over the whole device. This will cause the insulating layers **24** to be formed under the p-channel and n-channel devices simultaneously, and adds minimal complexity to the overall fabrication process flow.

The resulting transistor structure has a number of features which distinguish it from prior art structures. The presence of the insulating layer **24** lowers the source/drain junction capacitance, which improves the switching speed of the transistor. Since the channel does not need to be relatively highly doped, a high channel mobility is maintained and device performance, such as transistor gain, does not suffer. The transistor tends to have improved short-channel characteristics in general, since the extent of the lateral field is reduced. This helps minimize source/drain punch through. In addition, the presence of the insulating layer **24** can help minimize latch up problems in a CMOS device, because the parasitic bipolar device which is connected from the source/drain region to an adjacent well of the opposite conductivity type is interrupted by the insulating layer **24**.

While the invention has been particularly shown and described with reference to a preferred embodiment, it will be understood by those skilled in the art that various changes in form and detail may be made therein without departing from the spirit and scope of the invention.

## Claims

1. A method for fabricating a field effect transistor, comprising the steps of:
forming a gate electrode over a substrate;
implanting a dopant below the surface to form an insulating layer; and
forming source/drain regions in the substrate above the insulating layer and adjacent the gate electrode.

2. The method of Claim 1, further comprising the step of:
before said source/drain forming step, heating the substrate to convert the implanted dopant into an insulating layer comprised of the dopant and silicon.

3. The method of Claim 2, wherein said heating step comprises a rapid thermal anneal.

4. The method of Claim 1, wherein said source/drain forming step comprises the steps of:
implanting a relatively light dose of dopant into the substrate to form lightly doped drain regions;
forming sidewall spacers alongside the gate electrode; and
implanting a heavy dose of dopant into the substrate to form heavily doped source/drain regions.

5. The method of Claim 1, further comprising the step of:
before said dopant implanting step, forming sidewall spacers alongside the gate electrode.

6. The method of Claim 5, further comprising the step of:
before said sidewall forming step, implanting a relatively light dose of dopant into the substrate to form lightly doped drain regions.

7. The method of Claim 1, wherein the gate electrode is formed with an overlying blocking layer, whereby the dopant implanted to form the insulating layer below the surface does not penetrate to conductive portions of the gate electrode.

8. A method of fabricating a field effect transistor, comprising the steps of:
forming a gate electrode over a substrate;
implanting a dopant below the surface to form an insulating layer, wherein the gate electrode blocks the implant from an underlying channel region;
implanting a relatively light dose of dopant into the substrate to form lightly doped drain regions;
forming sidewall spacers alongside the gate electrode; and
implanting a heavy dose of dopant into the substrate to form heavily doped source/drain regions.

9. A method for fabricating a field effect transistor, comprising the steps of:
forming a gate electrode over a substrate;
implanting a relatively light dose of dopant into the substrate to form lightly doped drain regions;
forming sidewall spacers alongside the gate electrode;
implanting a dopant below the surface to form an insulating layer, wherein the gate electrode and sidewall spacers block the implant from an underlying channel region; and
implanting a heavy dose of dopant into the substrate to form heavily doped source/drain regions.

10. The method of Claim 8 or 9 wherein said step of forming a gate electrode comprises the steps of:
forming a gate oxide layer over the substrate;
forming a polycrystalline silicon layer over the gate oxide layer;
forming a blocking layer over the polycrystalline silicon layer; and
patterning and etching the polycrystalline silicon and blocking layers to define a gate electrode.

11. The method of any one of Claims 1, 8 or 9, wherein the dopant implanted to form the insulating layer comprises oxygen.

12. The method of any one of Claims 1, 8 or 9, wherein the dopant implanted to form the insulating layer comprises nitrogen.

13. A field effect transistor structure, comprising:
a substrate;
a gate electrode overlying said substrate;
a relatively thin insulating layer within said substrate and parallel to an upper surface thereof, wherein said insulating layer does not underlie said gate electrode; and
source/drain regions within said substrate between the upper surface and said insulating layer.

14. The structure of Claim 13, further comprising:
lightly doped drain regions disposed between said source/drain regions and a channel region underlying said gate electrode.

15. The structure of Claim 14, wherein said insulating layer does not underlie said lightly doped drain regions.

16. The structure of Claim 13, wherein said insulating layer comprises oxide.

17. The structure of Claim 13, wherein said insulating layer comprises nitride.

18. The structure of Claim 13, wherein said insulating layer is spaced laterally from under said gate electrode.

19. The structure of Claim 18, further comprising:
sidewall spacers alongside said gate electrode;
wherein said insulating layer is spaced laterally from under said gate electrode by a distance equivalent to a width of said sidewall spacers.
